## Europäisches Patentamt
### European Patent Office
### Office européen des brevets

(19)

(11) Veröffentlichungsnummer: **0 239 861**
**B1**

(12)

# EUROPÄISCHE PATENTSCHRIFT

(45) Veröffentlichungstag der Patentschrift:
20.06.90

(51) Int. Cl.⁵: **H03K 17/04**

(21) Anmeldenummer: 87103848.5

(22) Anmeldetag: 17.03.87

(54) MOSFET-Schalter mit induktiver Last.

(30) Priorität: 19.03.86 DE 3609235

(43) Veröffentlichungstag der Anmeldung:
07.10.87 Patentblatt 87/41

(45) Bekanntmachung des Hinweises auf die Patenterteilung:
20.06.90 Patentblatt 90/25

(84) Benannte Vertragsstaaten:
DE FR GB IT SE

(56) Entgegenhaltungen:
DE-A- 3 405 936

INSTRUMENTS AND EXPERIMENTAL TECHNIQUES,
Band 27, Nr. 5, Zeile 1, Sept.-Okt. 1984,
Seiten 1159-1161, Plenum Publishing Corp., New York,
US; V.V. BACHURIN et al.: "Heavy-current nanosecond
pulse shapers using high-power MOS transistors with a
vertical channel"rimidin-5-ones"NDEX, CHEMICAL
SUBSTANCES, page 52194cs, right-hand column, 3rd
compound 000
NEW ELECTRONICS, Band 18, Nr. 11, 28. Mai 1985,
Seiten 44,46, London, GB; M. ALEXANDER et al.:
"Designing improved high speed gate drive circuit"
PATENT ABSTRACTS OF JAPAN, Band 9,
Nr. 266 (E-352)[1989], 23. Oktober 1985 &
JP-A-60-113 524

(73) Patentinhaber: Siemens Aktiengesellschaft,
Wittelsbacherplatz 2, D-8000 München 2(DE)

(72) Erfinder: Einzinger, Josef, Dipl.-Ing., Am Weiher 21,,
D-8044 Unterschleissheim(DE)
Erfinder: Fellinger, Christine, Von Stauffenberg
Strasse 3, D-8025 Unterhaching(DE)
Erfinder: Leipold, Ludwig, Dipl.-Ing., Strassberger
Strasse 125, D-8000 München 40(DE)
Erfinder: Tihanyi, Jenö, Dr., Windeck 1 d,,
D-8000 München 70(DE)
Erfinder: Weber, Roland, Dipl.-Ing., Ursulastrasse 5,,
D-8000 München 40(DE)

(56) Entgegenhaltungen: (Fortsetzung)
NACHRICHTENTECHNIK ELEKTRONIK, Band 32,
Nr. 9, 1982, Seiten 365-369, Ost-Berlin, DD; B.
SISOLEFSKY et al.: "Elektronische Analogschalter"

## Beschreibung

Die Erfindung bezieht sich auf eine Schaltungsanordnung mit einem Leistungs-MOSFET und einer induktiven Last, die zwischen dem Sourceanschluß des Leistungs-MOSFET und einer ersten Klemme liegt, und mit einer zweiten Klemme, die mit dem Drainanschluß des Leistungs-MOSFET verbunden ist.

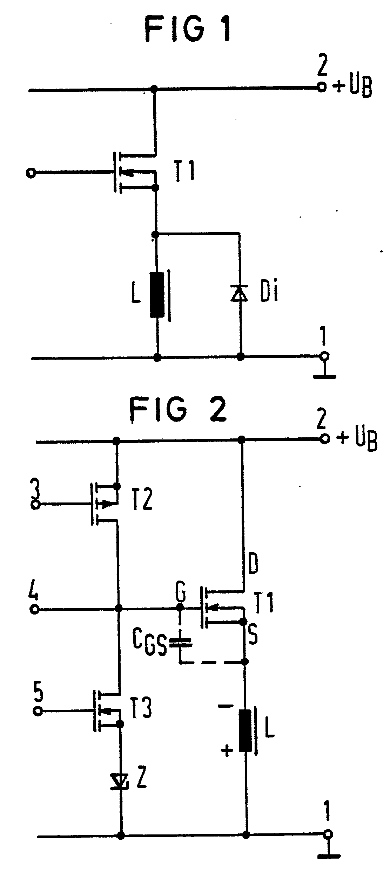

Eine solche Schaltungsanordnung ist beispielsweise in der Zeitschrift "electronic industrie", 4-1985, Seite 32 bis 38 beschrieben worden. In Fig. 1 der vorliegenden Anmeldung ist eine vereinfachte Darstellung dieser Schaltungsanordnung angegeben. Das Problem, die beim Abschalten einer induktiven Last auftretende negative Spannungsspitze zu begrenzen, wird hier in der allgemein üblichen Art dadurch gelöst, daß der dem Leistungs-MOSFET T 1 sourceseitig in Reihe geschalteten induktiven Last L eine Diode Di parallelgeschaltet wird. Damit wird zwar die beim Abschalten auftretende negative Spannungsspitze auf die Durchlaßspannung der Diode begrenzt, die in der Last L gespeicherte Energie wird jedoch aufgrund der geringen Höhe der treibenden Gegenspannung nur sehr langsam abgebaut.

Der Erfindung liegt die Aufgabe zugrunde, eine Schaltungsanordnung der erwähnten Gattung so weiterzubilden, daß die treibende Gegenspannung auf einen höheren Wert eingestellt und auf einen für den Leistungs-MOSFET ungefährlichen Wert begrenzt werden kann.

Diese Aufgabe wird dadurch gelöst, daß zwischen dem Gateanschluß des Leistungs-MOSFET und der ersten Klemme die Reihenschaltung aus einem Schalter und einer Zenerdiode angeschlossen ist und daß die Zenerdiode so gepolt ist, daß sie mit dem Schalter und der induktiven Last einen Entladestromkreis für die Gate-Source-Kapazität des Leistungs-MOSFET bildet.

Weiterbildungen der Erfindung sind Gegenstand der Unteransprüche.

Die Erfindung wird anhand eines Ausführungsbeispiels in Verbindung mit Fig. 2 näher erläutert:

Die Schaltungsanordnung nach Fig. 2 weist einen Leistungs-MOSFET T 1 auf, dem sourceseitig eine induktive Last L in Reihe geschaltet ist. Der dem Sourceanschluß von T 1 abgewandte Anschluß der induktiven Last L ist mit einer ersten Klemme 1 verbunden. Der Drainanschluß D von T 1 liegt an einer zweiten Klemme 2. Die Klemme 1 liegt beispielsweise auf Massepotential; an den Klemmen 1, 2 liegt die Betriebsspannung +$U_B$. Zwischen dem Gateanschluß G von T 1 und der ersten Klemme 1 liegt die Reihenschaltung aus einem Schalter und einer Zenerdiode Z. Der Schalter ist vorzugsweise ein MOSFET T 3 vom gleichen Kanaltyp wie T 1. Die Zenerdiode ist so gepolt, daß sich die Gate-Source-Kapazität $C_{GS}$ von T 1 über den MOSFET T 3, die Zenerdiode Z und die induktive Last L entladen kann. Der Entladestrom von $C_{GS}$ durchfließt die Zenerdiode Z daher in Flußrichtung.

Zur Erläuterung der Funktion wird vom leitenden Zustand des Leistungs-MOSFET T 1 ausgegangen.

Dann liegt an der Eingangsklemme 4 eine Spannung, die größer ist als die Betriebsspannung +$U_B$. Das Sourcepotential von T 1 liegt etwas unterhalb +$U_B$. Es fließt ein Strom von der Klemme 2 zur Klemme 1. Soll T 1 abgeschaltet werden, wird die Spannung an der Eingangsklemme 4 zu Null gemacht und der MOSFET T 3 durch Anlegen einer gegen Masse positiven Spannung eingeschaltet. Dann kann sich die Gate-Source-Kapazität $C_{GS}$ von T 1 entladen und T 1 beginnt zu sperren. Dem abnehmenden Strom wirkt die induktive Last L durch eine negative Spannung am Sourceanschluß S entgegen. Die Last L wirkt somit als Stromquelle und hält den Strom über die Klemme 1, die Betriebsspannungsquelle, die Klemme 2 und T 1 zunächst aufrecht. Die am Sourceanschluß S auftretende negative Spannung bewirkt über die kapazitive Kopplung auch eine negative Spannung am Gateanschluß G. Erreicht diese Spannung die Zenerspannung der Zenerdiode Z, z. B. -6 V, so bricht dies durch. Damit wird das Potential am Gateanschluß G auf die Zenerspannung abzüglich der Durchlaßspannung von T 3 begrenzt. Das heißt, daß die negative Spannung am Sourceanschluß S auf das Gatepotential zuzüglich der sich einstellenden Gate-Source-Spannung von T 1 begrenzt wird. Beträgt diese Spannung z. B. 3 V, so ist die maximale Spannung am Sourceanschluß S etwa -9 V gegen Masse. Diese Spannung ist für T 1 bei entsprechender Spannungsklasse ungefährlich. Außerdem ist die den Energieabbau in der Last L treibende Gegenspannung sehr viel größer als bei bekannten Lösungen. Der Schalter kann daher bei vergleichsweise hohen Frequenzen von z. B. 150 Hz betrieben werden bei einer induktiven Last von 15 mH.

Die den Leistungs-MOSFET T 1 einschaltende Spannung an der Klemme 4 kann beispielsweise durch eine Spannungsverdoppler-Schaltung erzeugt werden, wie sie beispielsweise in der Zeitschrift "Siemens Components", 4/84, Seiten 169 bis 170 beschrieben worden ist. Damit läßt sich aus der Betriebsspannung +$U_B$ durch schrittweises Aufladen eines Kondensators eine höhere Spannung als +$U_B$ erzielen. Der Einschaltvorgang läßt sich beschleunigen, wenn zwischen Gateanschluß G von T 1 und Klemme 2 ein weiterer MOSFET T 2 angeschlossen wird, der vom entgegengesetzten Kanaltyp wie T 1 ist. Wird T 2 durch ein Signal an seiner Eingangsklemme 3 eingeschaltet, so lädt sich die Kapazität $C_{GS}$ und der erwähnte Kondensator schnell auf die Betriebsspannung auf, so daß der erwähnte Kondensator zusätzlich nur noch um die Spannung weiter aufgeladen werden muß, die für ein gutes Durchschalten von T 1 nötig ist, z. B. 7 V.

Die Erfindung wurde anhand einer Schaltungsanordnung beschrieben, die an einer positiven Spannung betrieben wird. Für eine zwischen Masse und negativer Spannung betriebene Schaltungsanordnung werden MOSFET vom jeweils entgegengesetzten Kanaltyp verwendet. Die Polung der Zenerdiode ist dann entsprechend umzukehren.

## Patentansprüche

1. Schaltungsanordnung mit einem Leistungs-MOSFET und einer induktiven Last, die zwischen dem Sourceanschluß des Leistungs-MOSFET und einer ersten Klemme liegt, und mit einer zweiten Klemme, die mit dem Drainanschluß des Leistungs-MOSFET verbunden ist, dadurch gekennzeichnet, daß zwischen dem Gateanschluß (G) des Leistungs-MOSFET (T 1) und der ersten Klemme (1) die Reihenschaltung aus einem Schalter und einer Zenerdiode (Z) angeschlossen ist und daß die Zenerdiode so gepolt ist, daß sie mit dem Schalter und der induktiven Last (L) einen Entladestromkreis für die Gate-Source-Kapazität (C$_{GS}$) des Leistungs-MOSFET bildet.

2. Schaltungsanordnung nach Anspruch 1, dadurch gekennzeichnet, daß der Schalter ein MOSFET (T 3) vom gleichen Kanaltyp wie der Leistungs-MOSFET (T 1) ist.

3. Schaltungsanordnung nach Anspruch 1 oder 2, dadurch gekennzeichnet, daß zwischen dem Gateanschluß (G) des Leistungs-MOSFET (T 1) und der zweiten Klemme (2) ein weiterer Schalter angeschlossen ist.

4. Schaltungsanordnung nach Anspruch 3, dadurch gekennzeichnet, daß der weitere Schalter ein MOSFET (T 2) vom dem Leistungs-MOSFET (T 1) entgegengesetzten Kanaltyp ist.

## Claims

1. Circuit arrangement having a power MOSFET and an inductive load which lies between the source of the power MOSFET and a first terminal, and having a second terminal which is connected to the drain of the power MOSFET, characterized in that between the gate (G) of the power MOSFET (T1) and the first terminal (1) the series circuit of a switch and a Zener diode (Z) is connected, and in that the Zener diode is poled in such a way that it forms with the switch and the inductive load (L) a discharge circuit for the gate-source capacitance (C$_{GS}$) of the power MOSFET.

2. Circuit arrangement according to claim 1, characterized in that the switch is a MOSFET (T3) of the same channel type as the power MOSFET (T1).

3. Circuit arrangement according to claim 1 or 2, characterized in that between the gate (G) of the power MOSFET (T1) and the second terminal (2) a further switch is connected.

4. Circuit arrangement according to claim 3, characterized in that the further switch is a MOSFET (T2) of the opposite channel type to the power MOSFET (T1).

## Revendications

1. Montage comportant un transistor MOSFET de puissance et une charge inductive, disposée entre la borne de source du transistor MOSFET de puissance et une première borne, et comportant une seconde borne, reliée à la borne de drain du transistor MOSFET de puissance, caractérisé par le fait que le circuit série formé d'un interrupteur et d'une diode Zener Z est branché entre la borne de grille (G) du transistor MOSFET de puissance (T1) et la première borne (1), et que la diode Zener est polarisée de telle sorte qu'elle forme, avec l'interrupteur et la charge inductive (L), un circuit de décharge pour la capacité grille-source (C$_{GS}$) de puissance.

2. Montage suivant la revendication 1, caractérisé par le fait que l'interrupteur est un transistor. MOSFET (T3) possédant le même type de canal que le transistor MOSFET de puissance (T1).

3. Montage suivant la revendication 1 ou 2, caractérisé par le fait qu'un second interrupteur est branché entre la borne de grille (G) du transistor MOSFET de puissance (T1) et la seconde borne (2).

4. Montage suivant la revendication 3, caractérisé par le fait que l'autre interrupteur est un transistor MOSFET (T2) possédant le type de canal opposé à celui du transistor MOSFET de puissance (T1).

# FIG 1

# FIG 2